# DEMANDE DE BREVET EUROPEEN

(11) **EP 1 098 372 A2**
(43) Date de publication de la demande: **09.05.2001**
(21) Numéro de dépôt: 00403022.7
(22) Date de dépôt: 31.10.2000
(51) Int. Cl.: H01L 29/165, H01L 29/167, H01L 21/205

(54) **Procédé pour empêcher la diffusion de bore dans un composant semiconducteur par création de barrières d'azote, et composant obtenu**

(30) Priorité: 05.11.1999 FR 9913930
(71) Demandeur: FRANCE TELECOM, 75015 Paris (FR)
(72) Inventeur: Berenguer, Marc, 38420 Revel (FR)
(74) Mandataire: Casalonga, Axel

(57) **Abrégé**

L'invention concerne un procédé pour empêcher la diffusion du bore entre une première région d'un composant semiconducteur contenant du bore comme dopant et une seconde région dudit composant adjacente à la première région au cours de la fabrication du composant. Le procédé comprend le traitement d'une surface de ladite première région (7) ou de ladite seconde région (9) avec un mélange d'azote et d'hydrogène à basse pression pour former sur ladite surface traitée une couche parcellaire d'atomes d'azote (8,10), puis la formation de la seconde région (9) ou de la première région (11) sur ladite surface traitée avantageusement par épitaxie. De préférence le matériau de lat première ou seconde région est du silicium ou un alliage de silicium et germanium.

## Description

La présente invention concerne d'une manière générale un procédé pour empêcher la diffusion du bore présent comme dopant dans une région d'un composant semiconducteur de diffuser dans une région adjacente au cours de la fabrication du composant.

L'augmentation de la densité d'intégration des circuits ainsi que de leur rapidité de fonctionnement, conduit à une réduction constante de la dimension des transistors élémentaires et à une intégration de plus en plus poussée des circuits de composants à hétérojonction utilisant des couches formées par épitaxie. En effet, on peut utiliser des couches épitaxiées, par exemple à base de Si ou d'alliage SiGe pour réaliser des transistors ou des systèmes multicouches à puits quantiques.

Les technologies actuelles nécessitent des bilans thermiques importants, ce qui engendre des problèmes lors de l'utilisation d'un dopant tel que le bore dans les couches, car celui-ci a tendance à diffuser dans les couches adjacentes au cours de la fabrication, en particulier lors des traitements thermiques.

Pour résoudre ce problème, on a proposé des traitements de surface visant à créer une couche constituant une barrière à la diffusion tout en n'altérant pas la qualité de la surface.

Une technique utilisée à l'heure actuelle consiste à implanter des atomes d'azote dans la surface. Cette implantation résulte en une présence d'atomes d'azote à l'interface qui évite la diffusion du bore dans les couches adjacentes tout en conservant à la surface une composition permettant la formation par épitaxie de la couche ultérieure.

Toutefois, cette technique présente plusieurs inconvénients.

Tout d'abord, elle oblige la mise en oeuvre d'un appareil d'implantation. Il s'agit d'un appareil complexe et coûteux. De ce fait, le coût du procédé est onéreux.

D'autre part, la mise au point de cette technique exige l'emploi d'une source spéciale .

En outre, une fois l'implantation réalisée, il est nécessaire d'effectuer un recuit de la surface traitée pour éliminer les dommages causés par l'implantation, car une telle implantation ne peut s'effectuer sans un certain endommagement du cristal.

Enfin, cette technique ne peut se faire in situ, c'est-à-dire en utilisant le même appareillage que les autres étapes de fabrication du composant, ce qui accroit le nombre des manipulations nécessaires pour la fabrication du composant.

L'invention propose donc un procédé pour empêcher la diffusion du bore entre une première région d'un composant semiconducteur contenant du bore comme dopant et une seconde région dudit composant adjacente à la première région au cours de la fabrication du composant. D'une façon générale, le procédé selon l'invention comprend le traitement d'une surface de ladite première région ou de ladite seconde région avec un mélange d'azote et d'hydrogène à basse pression pour former sur ladite surface traitée une couche parcellaire d'atomes d'azote, puis la formation de la seconde région ou de la première région sur ladite surface traitée.

De préférence, le traitement de la surface s'effectue par dépôt chimique en phase vapeur (CVD) à basse pression.

Selon une caractéristique avantageuse de l'invention, ledit mélange d'azote et d'hydrogène est composé, en volume, de 50% d'azote et 50% d'hydrogène.

Préalablement au traitement de la surface avec le mélange d'azote et d'hydrogène à basse pression, on peut effectuer un pré-traitement de la surface avec de l'hydrogène à une température à 900°. L'étape de pré-traitement permet de préparer la surface à traiter en la nettoyant et rendant réactives les liaisons chimiques de ladite surface.

A titre d'exemple, la première région peut être constituée par du silicium ou un alliage de silicium et de germanium dopé avec du bore. Par ailleurs, la deuxième région peut être constituée par du silicium.

Selon un mode de réalisation préféré, lorsque la surface traitée est la surface de la première région, le traitement s'effectue à une température correspondant à la température de formation de cette première région.

Selon une caractéristique de l'invention, la température de traitement de la surface de la première région est de 600 à 1000°C, de préférence 600 à 800°C.

Selon une autre caractéristique de l'invention, lorsque la surface traitée est la surface de la seconde région, le traitement s'effectue à une température de 600 à 1000°C, de préférence 600 à 800°C.

D'une façon générale, l'invention a également pour objet un procédé pour empêcher la diffusion du bore contenu comme dopant dans une première couche d'un matériau semiconducteur d'un composant semiconducteur formée sur un substrat en matériau semiconducteur et surmontée d'une deuxième couche d'un matériau semiconducteur, au cours de la fabrication du composant. Selon l'invention, le procédé comprend :
a) le traitement d'une surface dudit substrat avec un mélange d'azote et d'hydrogène à basse pression pour former sur ladite surface traitée une couche parcellaire d'atomes d'azote,
b) la formation de ladite première couche d'un matériau semiconducteur dopé avec du bore sur ladite surface traitée du substrat,
c) le traitement de la surface supérieure de ladite première couche d'un matériau semiconducteur formée à l'étape b) avec un mélange d'azote et d'hydrogène à basse pression pour former sur ladite surface traitée une couche parcellaire d'atomes d'azote, et
d) la formation sur la surface traitée de ladite première couche d'un matériau semiconducteur dopé avec du bore de la deuxième couche d'un matériau semiconducteur.

Le matériau semiconducteur de la première couche peut être du silicium ou un alliage de silicium et germanium cristallin ou amorphe et le matériau semiconducteur de la deuxième couche peut être du silicium ou un alliage silicium-germanium cristallin ou amorphe. De préférence le matériau semiconducteur des couches est du silicium cristallin.

Enfin, l'invention concerne également un composant semiconducteur comprenant un substrat et une couche semiconductrice dopée avec du bore, caractérisé en ce que ladite couche semiconductrice est prise en sandwich entre deux couches parcellaires d'atomes d'azote dont l'une des deux est réalisée entre le substrat et ladite couche semiconductrice.

D'autres avantages et caractéristiques de l'invention apparaîtront à l'examen de la description détaillée d'un mode de mise en oeuvre et des dessins annexés qui représentent respectivement :
- figure 1, un organigramme des étapes du procédé selon l'invention, et
- figure 2, une structure semiconductrice selon l'invention.

Bien que l'invention n'y soit pas limitée, on va maintenant décrire l'application du procédé selon l'invention à la formation d'une structure épitaxiée composée d'un substrat en silicium, une couche SiGe dopé avec du bore et une couche supérieure en silicium. En effet, l'invention peut par exemple concerner également une structure en polysilicium composée d'un substrat en silicium, une couche en polysilicium-germanium et une couche supérieure en polysilicium.

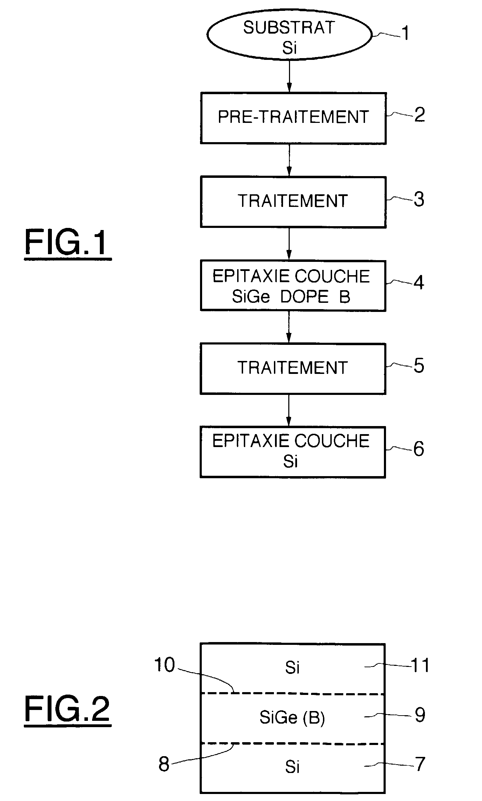

On voit sur la figure 1 l'ensemble des étapes réalisées selon l'invention à partir d'un substrat de silicium 1 recouvert d'une couche d'oxyde de silicium SiO2. Différentes couches vont être déposées sur le substrat de silicium. La première étape consiste à un pré-traitement 2 de façon à préparer la surface du substrat 1. Pour ce faire, on dissout l'oxyde de silicium SiO2 en portant le substrat à une température de l'ordre de 1000°C en la présence d'hydrogène dans un réacteur pour dépôt en phase vapeur CVD (Chemical Vapor Deposition) à basse pression. Ce type de réacteur permet des montées en température très rapide, de l'ordre de quelques secondes, pour passer de la température ambiante à 1000°C, ce qui autorise des fronts de variations de températures très raide. La surface du substrat est ainsi nettoyée et les liaisons chimiques de silicium de cette surface sont ouvertes et aptes à accueillir des atomes réactifs.

La seconde étape est le traitement 3 de la surface du substrat 1 pour former une première couche parcellaire d'atomes d'azote. On injecte les atomes d'azote et d'hydrogène dans le réacteur CVD sous forme d'un mélange composé de 50% d'azote et 50% d'hydrogène à une température de 900°C. Le mélange est réalisé en fixant le même débit pour les deux gaz d'azote et d'hydrogène. L'adjonction d'hydrogène provoque la dissociation des molécules d'azotes de façon à les rendre réactives et faciliter leurs fixations sur les liaisons de silicium libres. Le traitement réalisé permet de former une couche dite parcellaire car les atomes d'azotes ne recouvrent pas complètement la surface du substrat du fait notamment d'une durée de traitement de quelques secondes. Toutes les liaisons chimiques de silicium de la surface du substrat ne sont pas occupées par les atomes d'azotes. Une véritable couche continue de nitrure (Si3N4) ne se forme pas car celle-ci se forme généralement par injection d'atomes de silicium et d'azote sous forme gazeuse. Le traitement 3 met en oeuvre deux phénomènes simultanés, la dissociation des molécules d'azote pour créer des atomes, et la fixation par endroit de ces atomes sur la surface de silicium du substrat.

La première couche parcellaire ainsi réalisée comporte des endroits où des liaisons libres de silicium ne sont pas occupées.

L'étape 4 consiste en la réalisation de la couche de silicium-germanium SiGe dopée avec du bore. Etant donné que la surface du substrat comporte encore des liaisons de silicium laissées libres par la première couche parcellaire, on peut faire croître par épitaxie la couche de SiGe dopée avec le bore sans rencontrer de problèmes au niveau de l'adhérence de l'empilement. La croissance par épitaxie de la couche SiGe est réalisée en utilisant comme précurseurs gazeux les composés SiH4, SiGe et B2H6 à une température de 900°C.

A l'étape 5 on effectue le traitement de la surface de la couche de SiGe pour former une seconde couche parcellaire d'atomes d'azote dans les mêmes conditions que la formation de la première couche parcellaire de l'étape 3, en particulier à une température de 900°C.

Cependant, il est possible de réaliser la première couche parcellaire d'atomes d'azote de l'étape 3 avec une température différente de 900°C qui est la température de croissance par épitaxie 4 de la couche SiGe dopée avec le bore. En effet, la première couche parcellaire est formée sur un substrat de silicium non dopée, donc ne contenant pas de bore susceptible de diffuser. On peut former la première couche parcellaire à une température de 950°C par exemple avec un temps de formation inférieur à celui prévu pour la formation à 900°C.

Enfin, l'étape 6 concerne la croissance par épitaxie d'une couche supérieure de silicium sur la seconde couche parcellaire d'atomes d'azote.

La couche de SiGe dopée avec le bore est prise en sandwich entre deux couches parcellaires d'atomes d'azote. Les deux couches parcellaires ont pour rôle d'empêcher la diffusion du bore dans le substrat de silicium et dans la couche supérieure de silicium.

La figure 2 illustre un composant tel que réalisé selon le processus de la figure 1. On distingue un substrat de silicium 7 sur lequel est formée une première couche parcellaire d'atomes d'azote 8. Une couche 9 d'alliage silicium-germanium SiGe dopée avec du bore est réalisée sur la première couche parcellaire 8 par épitaxie. Le bore présent dans la couche 9 ne diffuse pas vers le substrat 7 de silicium car la première couche parcellaire 8 comporte suffisamment d'atomes d'azote pour empêcher cette diffusion. Une seconde couche parcellaire 10 est formée sur la couche 9 SiGe dopée avec le bore de façon à empêcher la diffusion du bore vers une couche de silicium 11 réalisée par épitaxie sur cette seconde couche parcellaire 10. La structure ainsi réalisée avec deux couches parcellaires comporte 2*10¹⁵ atomes d'azote par cm². L'ensemble de la structure peut ensuite subir un recuit à 900°C sans que le bore présent dans la couche 9 ne diffuse vers les couches 7 et 11.

L'invention ainsi décrite ne nécessite pas une mise en oeuvre difficile car la formation des couches parcellaires d'atomes d'azote se réalisent in-situ à la même température que la formation par épitaxie des couches de SiGe ou Si recouvrant ces couches dites parcellaires. En outre, la formation de deux couches parcellaires selon l'invention n'implique qu'une durée supplémentaire d'une trentaine de secondes par rapport à la réalisation d'une structure identique à celle de la figure 2 sans formation des deux couches parcellaires.

## Revendications

1. Procédé pour empêcher la diffusion du bore entre une première région d'un composant semiconducteur contenant du bore comme dopant et une seconde région dudit composant adjacente à la première région au cours de la fabrication du composant, caractérisé en ce qu'il comprend le traitement d'une surface de ladite première région ou de ladite seconde région avec un mélange d'azote et d'hydrogène à basse pression pour former sur ladite surface traitée une couche parcellaire d'atomes d'azote, puis la formation de la seconde région ou de la première région sur ladite surface traitée.

2. Procédé selon la revendication précédente, caractérisé en ce que le traitement de la surface s'effectue par dépôt chimique en phase vapeur (CVD) à basse pression.

3. Procédé selon la revendication 1 ou 2, caractérisé en ce que ledit mélange d'azote et d'hydrogène est composé, en volume, de 50% d'azote et 50% d'hydrogène.

4. Procédé selon l'une quelconque des revendications 1 à 3, caractérisé en ce qu'il comprend préalablement au traitement de la surface avec le mélange d'azote et d'hydrogène à basse pression un pré-traitement de la surface avec de l'hydrogène à une température à 900°C.

5. Procédé selon l'une quelconque des revendications 1 à 4, caractérisé en ce que la première région est constituée par du silicium ou un alliage de silicium et de germanium dopé avec du bore.

6. Procédé selon l'une quelconque des revendications 1 à 5, caractérisé en ce que la deuxième région est constituée par du silicium.

7. Procédé selon l'une quelconque des revendications précédentes caractérisé en ce que, lorsque la surface traitée est la surface de la première région, le traitement s'effectue à une température correspondant à la température de formation de cette première région.

8. Procédé selon la revendication 7, caractérisé en ce que la température est de 600 à 1000°C, de préférence 600 à 800°C.

9. Procédé selon l'une quelconque des revendications 1 à 6, caractérisé en ce que, lorsque la surface traitée est la surface de la seconde région, le traitement s'effectue à une température de 600 à 1000°C, de préférence 600 à 800°C.

10. Procédé pour empêcher la diffusion du bore contenu comme dopant dans une première couche d'un matériau semiconducteur d'un composant semiconducteur formée sur un substrat en matériau semiconducteur et surmontée d'une deuxième couche d'un matériau semiconducteur, au cours de la fabrication du composant, caractérisé en ce que qu'il comprend :
a) le traitement d'une surface dudit substrat avec un mélange d'azote et d'hydrogène à basse pression pour former sur ladite surface traitée une couche parcellaire d'atomes d'azote,
b) la formation de ladite première couche d'un matériau semiconducteur dopé avec du bore sur ladite surface traitée du substrat,
c) le traitement de la surface supérieure de ladite première couche d'un matériau semiconducteur formée à l'étape b) avec un mélange d'azote et d'hydrogène à basse pression pour former sur ladite surface traitée une couche parcellaire d'atomes d'azote, et
d) la formation sur la surface traitée de ladite première couche d'un matériau semiconducteur dopé avec du bore de la deuxième couche d'un matériau semiconducteur.

11. Procédé selon la revendication précédente, caractérisé en ce que le traitement de la surface du substrat et de la surface de la première couche s'effectue par dépôt chimique en phase vapeur (CVD) à basse pression.

12. Procédé selon la revendication 10 ou 11, caractérisé en ce que ledit mélange d'azote et d'hydrogène est composé, en volume, de 50% d'azote et 50% d'hydrogène.

13. Procédé selon l'une quelconque des revendications 11 à 12, caractérisé en ce qu'il comprend préalablement au traitement de la surface du substrat et de la surface de la première couche avec le mélange d'azote et d'hydrogène à basse pression un pré-traitement des dites surfaces avec de l'hydrogène à une température à 900°C.

14. Procédé selon l'une quelconque des revendications 10 à 13, caractérisé en ce que ladite première couche d'un matériau semiconducteur est constituée par du silicium ou un alliage de silicium et de germanium dopé avec du bore.

15. Procédé selon l'une quelconque des revendications 10 à 14, caractérisé en ce que la deuxième couche est constituée par du silicium.

16. Procédé selon l'une quelconque des revendications 10 à 15, caractérisé en ce que ladite deuxième couche d'un matériau semiconducteur est formée par épitaxie.

17. Procédé selon l'une quelconque des revendications 10 à 14, caractérisé en ce que ladite deuxième couche d'un matériau semiconducteur est une couche de poly-silicium amorphe.

18. Composant semiconducteur comprenant un substrat et une couche semiconductrice dopée avec du bore, caractérisé en ce que ladite couche semiconductrice est prise en sandwich entre deux couches parcellaires d'atomes d'azote dont l'une des deux est réalisée entre le substrat et ladite couche semiconductrice.
